# EUROPEAN PATENT APPLICATION

(11) **EP 4 614 664 A1**
(43) Date of publication of application: **10.09.2025**
(21) Application number: 25152515.0
(22) Date of filing: 17.01.2025
(51) Int. Cl.: H01M 10/42, H01M 4/08

(54) **METHOD AND APPARATUS FOR INSPECTING DRY ELECTRODE**

(30) Priority: 26.01.2024 KR 20240012094
(71) Applicant: SAMSUNG SDI CO., LTD., Yongin-si, Gyeonggi-do 17084 (KR)
(72) Inventor: Yoo, Chijong, 17084 Yongin-Si Gyeonggi-do (KR); Lee, Jinhyon, 17084 Yongin-Si Gyeonggi-do (KR); Kwon, Seunguk, 17084 Yongin-Si Gyeonggi-do (KR); Kwon, Ilkyong, 17084 Yongin-Si Gyeonggi-do (KR); Bang, Seunggwon, 17084 Yongin-Si Gyeonggi-do (KR)
(74) Representative: Gulde & Partner

(57) **Abstract**

An apparatus for inspecting a dry electrode, the apparatus including: a feeder to feed a dry electrode film (110, 210, 410, 610, 710, 812) corresponding to a freestanding film; a resistance sensor (120, 220_1, 220_2, 220_3, 420, 620_1, 620_2, 620_3, 620_4, 720, 814) to contactlessly measure an electrical resistance value of the dry electrode film (110, 210, 410, 610, 710, 812) fed by the feeder; and a trimmer (640, 730) to remove an edge portion (114, 614) having a width from a widthwise end portion of the dry electrode film (110, 210, 410, 610, 710, 812).

## Description

### BACKGROUND

### 1. Field

Aspects of embodiments of the present disclosure relate to a method and an apparatus for inspecting a dry electrode.

### 2. Description of the Related Art

Unlike primary batteries that are not designed to be (re)charged, secondary (or rechargeable) batteries are batteries that are designed to be discharged and recharged. Low-capacity secondary batteries are used in portable, small electronic devices, such as smart phones, feature phones, notebook computers, digital cameras, and camcorders, while large-capacity secondary batteries are widely used as power sources for driving motors in hybrid vehicles and electric vehicles and for storing power (e.g., home and/or utility scale power storage). A secondary battery generally includes an electrode assembly composed of a positive electrode and a negative electrode, a case accommodating the same, and electrode terminals connected to the electrode assembly.

In a wet process for manufacturing electrodes included in secondary batteries, electrodes are manufactured by wet coating in which electrode materials are mixed with a solvent. However, such a wet process may have the possibility of solvent contamination, and the process of removing and drying the solvent may be costly and time-consuming.

The above information disclosed in this Background section is for enhancement of understanding of the background of the present disclosure, and therefore, it may contain information that does not constitute related (or prior) art.

### SUMMARY

The invention is defined by the appended claims. The description that follows is subjected to this limitation. Any disclosure lying outside the scope of said claims is only intended for illustrative as well as comparative purposes.

A dry process has recently been developed to manufacture electrodes without the use of solvents, unlike the comparative wet process. In the dry process, the dispersibility of materials on the film may be reduced compared to that of the wet process due to the absence of a solvent, and thus, a method to suitably measure the dispersibility of such materials may be desired.

Embodiments of the present disclosure may be directed to a method and an apparatus for inspecting a dry electrode.

These and other aspects and features of the present disclosure will be described in or will be apparent from the following description of embodiments of the present disclosure.

According to one or more embodiments of the present disclosure, an apparatus for inspecting a dry electrode, includes: a feeder configured to feed a dry electrode film corresponding to a freestanding film; a resistance sensor configured to contactlessly measure an electrical resistance value of the dry electrode film fed by the feeder; and a trimmer configured to remove an edge portion having a width from a widthwise end portion of the dry electrode film.

The resistance sensor may be configured to form an electric field in a direction perpendicular to or substantially perpendicular to the dry electrode film by applying a first magnetic field to an induction coil of the resistance sensor. The electric field may have the form of an eddy-current, and a second magnetic field may be formed in a direction perpendicular to or substantially perpendicular to the electric field. The resistance sensor may be configured to measure the electrical resistance value of the dry electrode film based on changes in electrical properties (e.g., a current flowing in a pickup coil of the resistance sensor) caused by the second magnetic field.

According to another embodiment, the resistance sensor may be configured to measure an area including the entire or substantially the entire area of the dry electrode film after the resistance sensors.

According to another embodiment, the resistance sensor may include a plurality of sensors, wherein the plurality of sensors may be configured or set such that coverage areas thereof partially overlap with each other in order to measure the entirety or substantially the entirety of the dry electrode film. The entirety or substantially the entirety of the dry electrode film may be a proportion of a measured area of the total area that is at least 90 %.

According to another embodiment, the resistance sensor may include a plurality of sensors, wherein at least two of the plurality of sensors may be positioned on the widthwise opposite ends of the dry electrode film. In other words, one of the plurality of sensors is disposed on one of the widthwise opposite ends of the dry electrode film and another one of the plurality of sensors is disposed on another one of the widthwise opposite ends of the dry electrode film.

According to another embodiment, the resistance sensor may include a plurality of sensors, wherein at least two of the plurality of sensors may be positioned on the lengthwise opposite ends of the dry electrode film to correspond to each other.

According to one embodiment, the resistance sensor may include a first resistance sensor configured to measure the electrical resistance value of the dry electrode film from which the edge portion is removed by the trimmer. In other words, the first resistance sensor may be configured to measure the electrical resistance value of the dry electrode film not having the edge portion or in other words of the edge portion free dry electrode film. Parts of the electrode film may still have the edge portion while other parts do not have the edge portion anymore. In other words, the first resistance sensor may be configured to measure the electrical resistance value of an area or portion of the dry electrode film from which the edge portion is removed by the trimmer.

In an embodiment, the first resistance sensor may include a plurality of sensors in a line in a width direction of the dry electrode film from which the edge portion is removed. In other words, the plurality of sensors may be disposed in a line or disposed in a direction extending in a width direction.

According to another embodiment, the first resistance sensor may be configured to be moved back and forth in a width direction of the dry electrode film from which the edge portion is removed.

According to another embodiment, a speed at which the resistance sensor is moved may be determined based on a width of the dry electrode film and the feed rate of the dry electrode film.

According to another embodiment, the resistance sensor may further include a second resistance sensor configured to measure the electrical resistance value of the dry electrode film before the edge portion is removed. In other words, the second resistance sensor may be configured to measure the electrical resistance value of the dry electrode film still having the edge portion or in other words of the edge portion including dry electrode film. Parts of the electrode film may still have the edge portion while other parts do not have the edge portion anymore. In other words, the second resistance sensor may be configured to measure the electrical resistance value of an area or portion of the dry electrode film from which the edge portion is not removed by the trimmer.

According to another embodiment, the apparatus may further include a tension controller configured to control a movement speed of the dry electrode film fed by the feeder.

According to another embodiment, the resistance sensor may include a third resistance sensor configured to measure the electrical resistance value of the dry electrode film, the movement speed of which may be controlled by the tension controller.

According to another embodiment, the tension controller may be configured to adjust the movement speed of the dry electrode film by adjusting the tension of the dry electrode film being fed at a high speed. For example, as the tension of the dry electrode film is momentarily reduced, the movement speed of the dry electrode film may be reduced.

According to another embodiment, the tension controller may include at least one of a dancer roll or an accumulator roll. A dancer roll and an accumulator roll are specialized rolls. They regulate material tension and speed to ensure a consistent material flow. The dancer roll serves to regulate and stabilize the tension of a moving in the continuous production process. The roll may move up and down (or back and forth), adjusting the material flow. When the material slackens, the dancer roll may move to restore the tension. If tension increases, the roll may release material to prevent stretching or tearing. Dancer rolls are used for precise tension control essential for high product quality. An accumulator roll stores material and ensures that material is continuously available for the next production step. It also serves to buffer tension and balance fluctuations. The accumulator roll may store excess material by taking up additional length when the preceding or following process stops or slows down. It then may feed the material evenly when it is needed. Both types of rolls help maintain consistent material tension and speed, preventing production interruptions. The dancer roll dynamically regulates tension, while the accumulator roll stores excess material and supports continuous operations.

According to another embodiment, the feeder may be configured to feed the dry electrode film at a speed of 1 m/min to 500 m/min.

According to another embodiment, the apparatus may further include a defect detector configured to detect a defect point of the dry electrode film based on the electrical resistance value measured by the resistance sensor, a measurement time, and a movement speed of the dry electrode film.

According to one or more embodiments of the present disclosure, a method of inspecting a dry electrode, includes: feeding a dry electrode film corresponding to a freestanding film to a resistance sensor configured to contactlessly measure an electrical resistance value of the dry electrode film; and measuring the electrical resistance value of the dry electrode film using the resistance sensor.

According to another embodiment, the method may further include removing an edge portion having a width from a widthwise end portion of the dry electrode film.

According to another embodiment, the removing the edge portion may further include remove edge portions having widths from widthwise end portions of the dry electrode film using a trimmer.

According to another embodiment, the measuring of the electrical resistance value of the dry electrode film may include measuring the electrical resistance value of the dry electrode film from which the edge portion is removed by using a first resistance sensor.

In an embodiment, the first resistance sensor may include a plurality of sensors in a line in a width direction of the dry electrode film from which the edge portion is removed.

In an embodiment, the first resistance sensor may be configured to be moved back and forth in a width direction of the dry electrode film from which the edge portion is removed.

In an embodiment, the measuring of the electrical resistance value of the dry electrode film may include measuring the electrical resistance value of the dry electrode film before the edge portion is removed by using a second resistance sensor.

In an embodiment, the method may further include determining whether or not the dry electrode film is defective based on the electrical resistance value measured by the first resistance sensor and the electrical resistance value measured by the second resistance sensor.

In an embodiment, the measuring of the electrical resistance value of the dry electrode film may include controlling a movement speed of the dry electrode film from which the edge portion is removed by using a tension controller.

In an embodiment, the measuring of the electrical resistance value of the dry electrode film may further include measuring the electrical resistance value of the dry electrode film, the movement speed of which may be controlled by the tension controller, by using a third resistance sensor.

In an embodiment, the method may further include detecting a defect point of the dry electrode film based on the electrical resistance value measured by the resistance sensor, a measurement time, and a movement speed of the dry electrode film.

According to some embodiments of the present disclosure, the electrical resistance value of a dry electrode film may be measured without a direct contact with the dry electrode film. Accordingly, the electrical resistance value may be measured without damaging the dry electrode film. In addition, by measuring the electrical resistance value of a freestanding film produced in the dry process, a small difference in the electrical resistance value may be more easily identified.

According to some embodiments of the present disclosure, a defect point on the dry electrode film may be more easily detected and managed. Furthermore, the defect point may be stored as data, which may be used as data for future quality control. In addition, by physically marking the defect point, an operator may more easily identify the defect point.

Those described above, and other aspects and features not mentioned will be clearly understood by a person skilled in the art from the detailed description, described below.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings:
FIG. 1 illustrates an example of a method of inspecting a dry electrode according to one or more embodiments of the present disclosure;
FIG. 2 illustrates an example of measuring electrical resistance values of a dry electrode film according to one or more embodiments of the present disclosure;
FIG. 3 illustrates an example of an area from which the electrical resistance values are measured by the method of FIG. 2;
FIG. 4 illustrates an example of measuring electrical resistance values of a dry electrode film according to one or more embodiments of the present disclosure;
FIG. 5 illustrates an example of an area from which the electrical resistance values are measured by the method of FIG. 4;
FIG. 6 illustrates an example of measuring electrical resistance values of the dry electrode film according to one or more embodiments of the present disclosure;
FIG. 7 illustrates an example of measuring electrical resistance values of a dry electrode film according to one or more embodiments of the present disclosure;
FIG. 8 illustrates an example of detecting a defect point of a dry electrode film according to one or more embodiments of the present disclosure; and
FIG. 9 illustrates a flowchart showing an example of a method according to one or more embodiments of the present disclosure.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when a layer or element is referred to as being "between" two layers, it can be the only layer between the two layers, or one or more intervening layers may also be present. It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges would comply with the requirements of local patent laws.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may be disposed in contact with the upper (or lower) surface of the element, and another element may also be interposed between the element and the arbitrary element disposed on (or under) the element.

In addition, it will be understood that when a component is referred to as being "linked," "coupled," or "connected" to another component, the elements may be directly "coupled," "linked" or "connected" to each other, or another component may be "interposed" between the components".

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

As used herein, the term "module" or "part" refers to a software or hardware component, in which the "module" or "part" performs a specific function. However, the "module" or "part" is not limited to software or hardware component. The "module" or "part" may be configured to be in an addressable storage medium or may be configured to reproduce one or more processors. Therefore, for example, the "module" or "part" may include at least one of components, such as software components, object-oriented software components, class components, and task components, processes, functions, attributes, procedures, subroutines, segments of program codes, drivers, firmware, microcodes, circuits, data, databases, data structures, tables, arrays, or variables. Functions provided within the components and the "modules" or "parts" may be combined into smaller number of components and "modules" or "parts" or further divided into additional components and "modules" or "parts".

According to embodiments of the present disclosure, the "module" or "part" may be implemented as a processor and a memory. The term "processor" should be broadly interpreted as encompassing a general purpose processor, a central processing unit (CPU), a microprocessor, a digital signal processor (DSP), a controller, a microcontroller, a state machine, and the like. In some environments, the "processor" may also refer to an application-specific integrated circuit (ASIC), a programmable logic device (PLD), a field-programmable gate array (FPGA), and the like. For example, the "processor" may also refer to a combination of processing devices, such as a combination of a DSP and a microprocessor, a combination of a plurality of microprocessors, a combination of one or more microprocessors coupled with a DSP core, or any other such configuration. Further, the "memory" should be interpreted broadly as encompassing any electronic component capable of storing electronic information. The "memory" may also refer to various types of processor-readable media, such as random access memory (RAM), read-only memory (ROM), non-volatile random access memory (NVRAM), programmable read-only memory (PROM), erasable programmable read-only memory (EPROM), electrically erasable PROM (EEPROM), flash memory, magnetic or optical data storage, registers, and the like. In a case where the processor may read information from the memory and/or write information to the memory, the memory may be referred to as being in electronic communication with a processor. The memory integrated into a processor is in electronic communication with the processor.

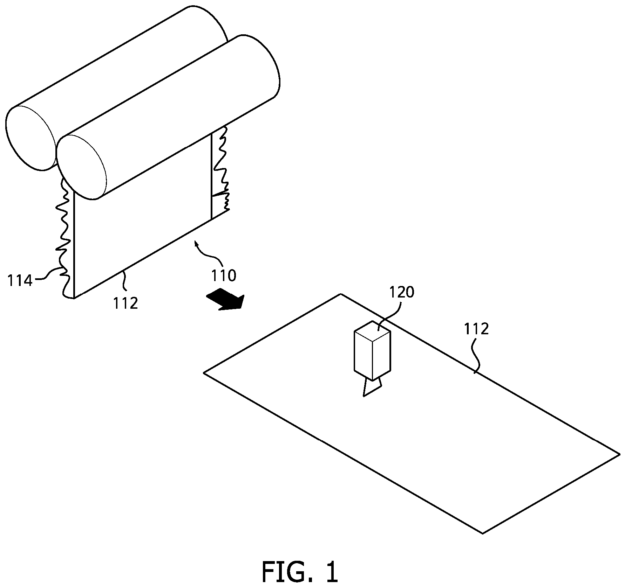

FIG. 1 illustrates an example of a method of inspecting a dry electrode according to one or more embodiments of the present disclosure.

In an embodiment, a dry electrode film 110 corresponding to a free standing film may be produced. In more detail, in a dry process, an active material, a conductive material, and a binder (e.g., polytetrafluoroethylene (PTFE) or the like) may be mixed with each other. Thereafter, the mixture may be fiberized using a kneader, and crushed using a crusher. Further, the dry electrode film 110 may be produced by rolling a crushed coating material rolled through a calendaring process. Herein, the dry electrode film 110 may have an uneven width due to the rolling. The dry electrode film 110 may include a central portion 112 having a width (e.g., a predetermined width) desirable for fabrication of a secondary cell, and edge portions 114 to be removed by a trimmer (or trimmers).

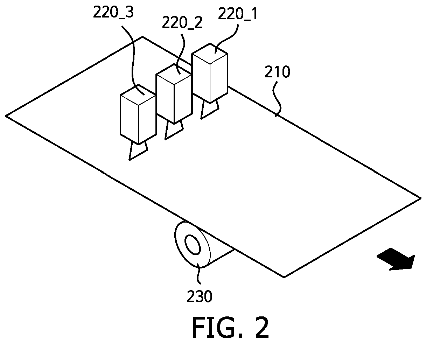

In an embodiment, the produced dry electrode film 110 may be fed to a resistance sensor 120 for measuring an electric resistance value. In more detail, the edge portions 114 may be removed from the widthwise end portions of the dry electrode film by the trimmer (not shown). Accordingly, the central portion 112 of the dry electrode film 110 having a constant or substantially constant width may be fed to the resistance sensor 120. The dry electrode film 110 may be fed at a speed of 1 m/min to 500 m/min. An example of the resistance sensor 120 for measuring an electrical resistance value of the dry electrode film 110 will be described in more detail below with reference to FIGS. 2 to 7.

In an embodiment, the resistance sensor 120 may measure an electrical resistance value of the dry electrode film 110 in a contactless manner. In more detail, an electric field may be formed in a direction perpendicular to or substantially perpendicular to the dry electrode film 110 by applying a first magnetic field to an induction coil of the resistance sensor 120. The electric field may have the form of an eddy-current, and a second magnetic field may be formed in a direction perpendicular to or substantially perpendicular to the electric field. The resistance sensor 120 may measure the electrical resistance value of the dry electrode film 110 based on changes in electrical properties (e.g., a current flowing in a pickup coil of the resistance sensor 120) caused by the second magnetic field. However, the contactless measuring method described above is for illustrative purposes only, and the method and structure for measuring the resistance sensor 120 may be variously modified as needed or desired.

The electrical resistance value of the dry electrode film may be measured at a distance from the dry electrode film without a direct contact with the dry electrode film. Accordingly, the electrical resistance value of the dry electrode film may be inspected without damaging the dry electrode film. Furthermore, small differences in the electrical resistance value may be more easily identified by measuring the electrical resistance value of the freestanding film produced in the dry process without a direct contact.

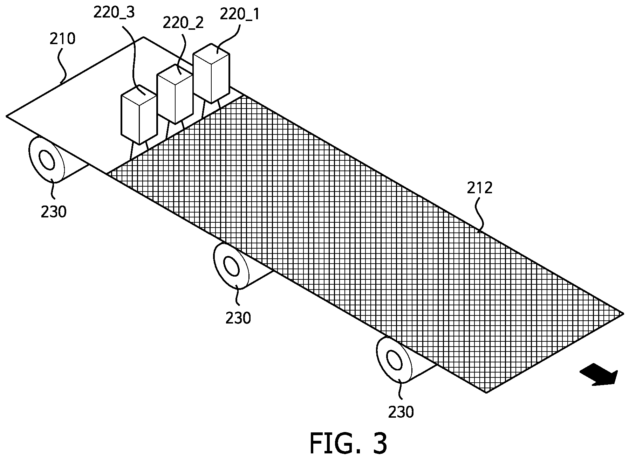

FIG. 2 illustrates an example of measuring electrical resistance values of a dry electrode film 210 according to one or more embodiments of the present disclosure. FIG. 3 illustrates an example of an area 212 from which the electrical resistance values are measured by the method of FIG. 2.

In an embodiment, the dry electrode film 210 may be fed to a plurality of resistance sensors 220_1 to 220_3 for contactlessly measuring the electrical resistance values through rollers 230. The dry electrode film 210 may refer to the central portion from which the edge portions having widths (e.g., predetermined widths) that are removed from widthwise end portions by a trimmer.

In an embodiment, the resistance sensors 220_1 to 220_3 may be arranged in a line in the width direction of the dry electrode film 210. Referring to FIG. 3, as the dry electrode film 210 is fed, the area 212 from which the electrical resistance values are measured may include the entire or substantially the entire area of the dry electrode film 210 after the resistance sensors 220_1 to 220_3. Accordingly, the electrical resistance values of the entire or substantially the entire area of the dry electrode film 210 may be measured contactlessly through the resistance sensors 220_1 to 220_3 arranged in a line.

For example, in a case where the number of the resistance sensors is n, where n is a natural number, each of the n resistance sensors may contactlessly measure the electrical resistance values over a coverage area corresponding to 1/n of the width of the dry electrode film 210 during the movement of the dry electrode film 210. For example, in a case where the resistance sensors include three resistance sensors, each of the resistance sensors may contactlessly measure the electrical resistance values during the movement of the dry electrode film 210 over the coverage area corresponding to 1/3 of the width of the dry electrode film 210.

For example, the resistance sensors may be configured or set such that the coverage areas thereof partially overlap with each other in order to measure the entirety or substantially the entirety of the dry electrode film 210. In a case where the resistance sensors are three sensors, each of the resistance sensors may contactlessly measure the electrical resistance values during the movement of the dry electrode film 210 over the coverage area corresponding to about 1/2.8 to 1/2.9 of the width of the dry electrode film 210.

Three resistance sensors 220_1 to 220_3 are shown in FIGS. 2 and 3, but other resistance sensors may be included, or some of the resistance sensors may be omitted, depending on the desired performance and position of the sensors.

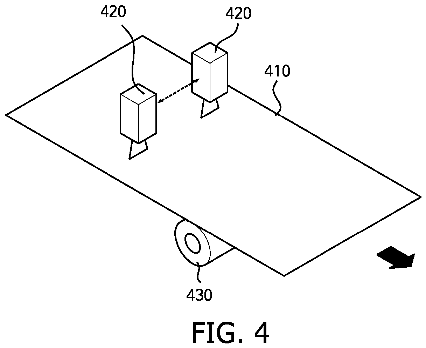

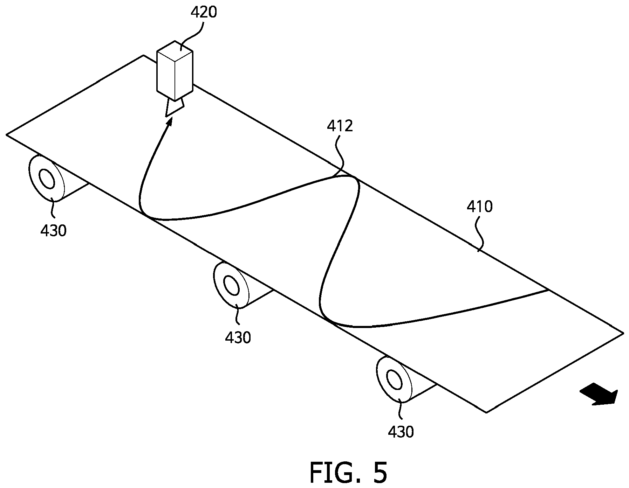

FIG. 4 illustrates an example of measuring electrical resistance values of a dry electrode film 410 according to one or more embodiments of the present disclosure. FIG. 5 illustrates an example of an area 412 from which the electrical resistance values are measured by the method of FIG. 4.

In an embodiment, the dry electrode film 410 may be fed to a resistance sensor 420 that contactlessly measures electrical resistance values through rollers 430. The dry electrode film 410 may refer to a central portion from which edge portions having widths (e.g., predetermined widths) are removed from widthwise end portions by a trimmer.

In an embodiment, the resistance sensor 420 may be moved back and forth in the width direction of the dry electrode film 410. The speed at which the resistance sensor 420 is moved may be determined based on the width of the dry electrode film 410 and the feed rate of the dry electrode film 410. Referring to FIG. 5, as the dry electrode film 410 is fed, the area 412 from which the electrical resistance values are measured may include a portion of the area of the dry electrode film 410 after the resistance sensor 420. This method of measuring the electrical resistance values may be suitable for high-speed production of the dry electrode film 410. Accordingly, the resistance sensor 420 that moves back and forth may be used to contactlessly measure the electrical resistance values of the dry electrode film 410 that is produced at a high speed.

A single resistance sensor 420 is shown in FIGS. 4 and 5, but the area 412 from which the electrical resistance values are measured may be increased by disposing at least one additional resistance sensor that is movable back and forth in the feed direction of the dry electrode film 410.

In FIGS. 4 and 5, the resistance sensor 420 is shown moving back and forth in the width direction of the dry electrode film 410, but the present disclosure is not limited thereto. For example, the resistance sensor 420 may measure the electrical resistance values of the dry electrode film 410 while moving in a direction in which the dry electrode film 410 is fed. In a case where the movement speed of the resistance sensor 420 and the feed rate of the dry electrode film 410 are the same or substantially the same as each other, the electrical resistance values of the dry electrode film 410 fed at a high speed may be measured more accurately with increases in the electrical resistance measurement time of the resistance sensor 420 for the area from which the electrical resistance values are measured. In this case, by positioning additional resistance sensors in the width direction of the dry electrode film 410, the area from which the electrical resistance values of the dry electrode film 410 fed at a high speed are measured may be increased.

Compared to the measuring method shown in FIG. 2, the measuring method shown in FIG. 4 may measure the electrical resistance values of the dry electrode film 410 at a higher speed with a reduced number of resistance sensors.

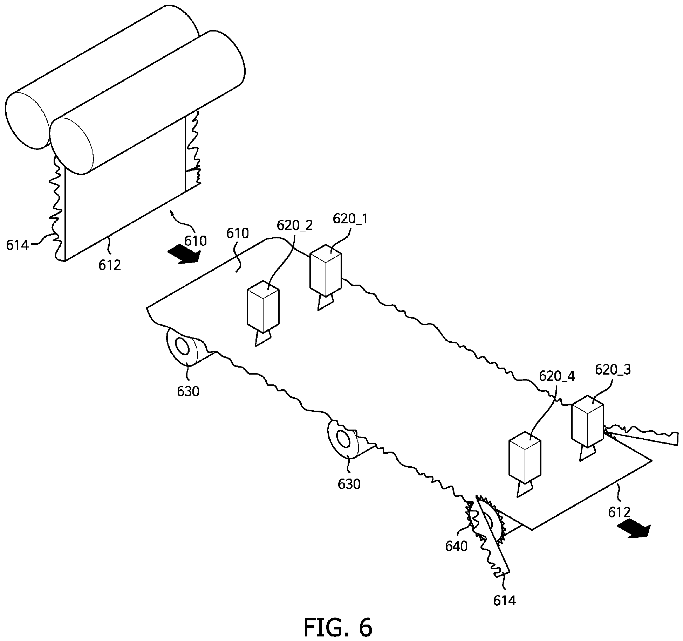

FIG. 6 illustrates an example of measuring electrical resistance values of the dry electrode film 610 according to one or more embodiments of the present disclosure.

In an embodiment, the dry electrode film 610 may be fed through the rollers 630 to a plurality of resistance sensors 620_1 to 620_4 that contactlessly measures electrical resistance values. Herein, the dry electrode film 610 may have an uneven width due to rolling. In addition, the dry electrode film 610 may include a central portion 612 having a width (e.g., a predetermined width) desired for manufacturing secondary cells, and edge portions 614 to be removed by a trimmer 640.

In an embodiment, a first set of resistance sensors 620_1, 620_2 may measure electrical resistance values of the dry electrode film 610 before the edge portions 614 are removed. In more detail, the first set of resistance sensors 620_1 and 620_2 may be positioned on the widthwise opposite ends of the dry electrode film 610. In this case, the edge portions 614 may have an unbalanced shape, and thus, the electrical resistance value of the dry electrode film 610 may not be constant as the dry electrode film 610 is being fed.

In an embodiment, a second set of resistance sensors 620_3 and 620_4 may measure electrical resistance values of the dry electrode film 610 from which the edge portions 614 are removed. In more detail, the edge portions 614 may be removed by the trimmer 640. Further, the electrical resistance values of the central portion 612 of the dry electrode film 610 may be measured by the second set of resistance sensors 620_3 and 620_4. In this case, the resistance sensors 620_3 and 620_4 of the second set may be positioned on the widthwise opposite ends of the dry electrode film 610 to correspond to the first set of resistance sensors 620_1 and 620_2. Accordingly, based on the electrical resistance values measured by the first set of resistance sensors 620_1 and 620_2 and the electrical resistance value measured by the second set of resistance sensors 620_3 and 620_4, the uniformity of the trimming process by the trimmer 640 may be identified (e.g., may be checked), and whether or not the dry electrode film 610 is defective may be determined.

In FIG. 6, each of the first set of resistance sensors 620_1 and 620_2 and the second set of resistance sensors 620_3 and 620_4 is shown as including two resistance sensors, but the present disclosure is not limited thereto. For example, other resistance sensors may be included, or some of the resistance sensors may be omitted as needed or desired, depending on the desired performance and position of the sensors.

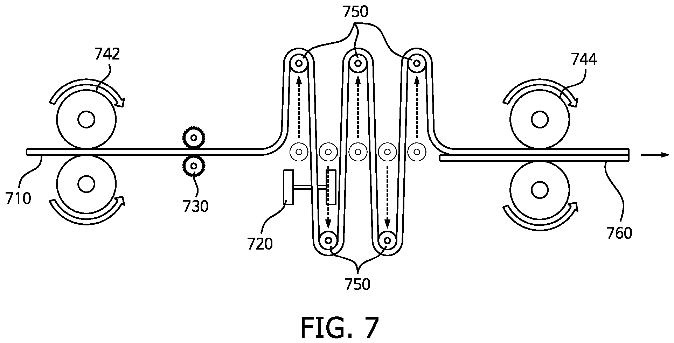

FIG. 7 illustrates an example of measuring electrical resistance values of a dry electrode film 710 according to one or more embodiments of the present disclosure.

In an embodiment, the dry electrode film 710 may be fed through first rollers 742 and second rollers 744 to a resistance sensor 720 that contactlessly measures an electrical resistance value. In this case, edge portions of the dry electrode film 710 may be removed by a trimmer 730.

In an embodiment, the movement speed of the dry electrode film 710 from which the edge portions are removed may be controlled by a tension controller 750. Herein, the tension controller 750 may include at least one of a dancer roll or an accumulator roll. Accordingly, the movement speed of the dry electrode film 710 may be adjusted by adjusting the tension of the dry electrode film 710 being fed at a high speed. For example, as the tension of the dry electrode film 710 is momentarily reduced, the movement speed of the dry electrode film 710 may be reduced.

In an embodiment, the resistance sensor 720 may measure the electrical resistance value of the dry electrode film 710, the movement speed of which is controlled by the tension controller 750. In this case, the resistance sensor 720 may measure the electrical resistance value of the opposite sides of the dry electrode film 710, but the present disclosure is not limited thereto. For example, as in the methods described above with reference to FIGS. 2 to 6, the resistance sensor 720 may measure the electrical resistance value of one side of the dry electrode film 710. Thereafter, the dry electrode film 710 having the measured electrical resistance value may be coated on a collector 760. In this case, the dry electrode film 710 and the collector 760 may be rolled together using the second rollers 744. Accordingly, the electrical resistance value of the dry electrode film 710 may be measured more accurately by controlling the feed rate of the dry electrode film 710.

In the electrical resistance measuring method described above with reference to FIG. 7, any of the electrical resistance measuring methods described above with reference to FIGS. 2 to 6 may be used. For example, the electrical resistance value of the dry electrode film 710, the movement speed of which is controlled, may be measured by a plurality of resistance sensors arranged in a line, but the present disclosure is not limited thereto.

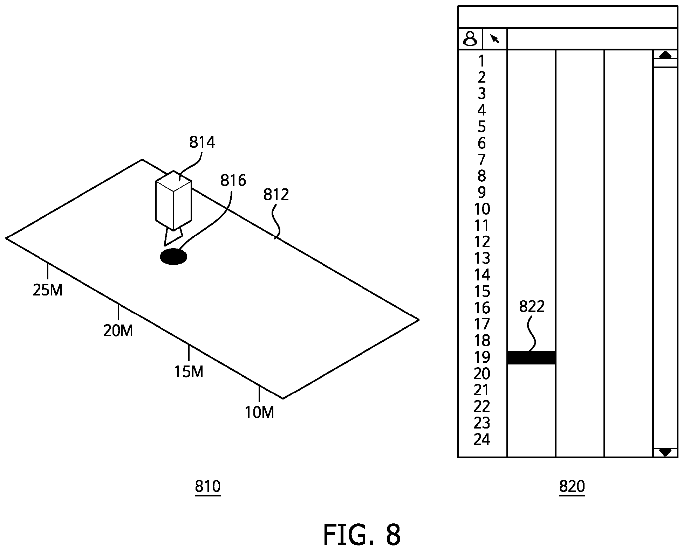

FIG. 8 illustrates an example of detecting a defect point of a dry electrode film 812 according to one or more embodiments of the present disclosure.

The first example 810 represents an example of detecting a defect point 816 of the dry electrode film 812 by the electrical resistance measuring method described above with reference to at least one of FIGS. 2 to 7. In an embodiment, the defect point 816 of the dry electrode film 812 may be detected based on an electrical resistance value of the dry electrode film 812 that is measured by the resistance sensor 814, a measurement time, and a movement speed of the dry electrode film 812. In more detail, in a case where the electrical resistance value of the dry electrode film 812 that is measured by the resistance sensor 814 is beyond a normal range, position information of the defect point may be automatically stored. The position information of the defect point may include information about a point (e.g., 19 M point) that the resistance sensor 814 is currently measuring based on the feed rate and the movement speed of the dry electrode film 812. The position information of such a defect point may be managed as data, or may be managed by displaying physical markings.

For example, the position of the resistance sensor 814 may also be used to detect the defect point 816 of the dry electrode film 812. In the electrical resistance measuring method illustrated in FIG. 2, in a case where three resistance sensors are used, information about which resistance sensor has detected a defect, and whether or not the defect has occurred in an area, may also be used. In another example, in the electrical resistance measuring method shown in FIG. 4, in a case where the resistance sensor is moved in the width direction of the dry electrode film, information about the distance of the movement of the resistance sensor with respect to the width direction of the dry electrode film may be additionally used.

A second example 820 represents an example in which a defect occurrence mark 822 is output on an interface. In an embodiment, the defect occurrence mark 822 may be output on the interface to indicate a position on the dry electrode film at which the defect occurred. For example, in a case where the defect has occurred at the 19 M point of the dry electrode film, the defect occurrence mark 822 may be displayed on the interface at the 19 M point of the dry electrode film. The defect occurrence mark 822 may be displayed in different colors depending on the kind of defect (e.g., a width defect or a scratch).

For example, in a case where the position information of the resistance sensor 814 is also available, the interface may also display the position information of the resistance sensor. For example, in a case where a plurality of resistance sensors are used, the IDs of the resistance sensors may also be displayed on the interface. In another example, in a case where the resistance sensors are moved in the width direction of the dry electrode film, information about the movement distances or positions of the resistance sensors may also be displayed on the interface.

As described above, defect points that occurred on the dry electrode film may be more easily detected and managed. Further, the defect points may be stored as data, which may be used as data for future quality control. In addition, by physically marking the defect points, an operator may more easily identify the defect points.

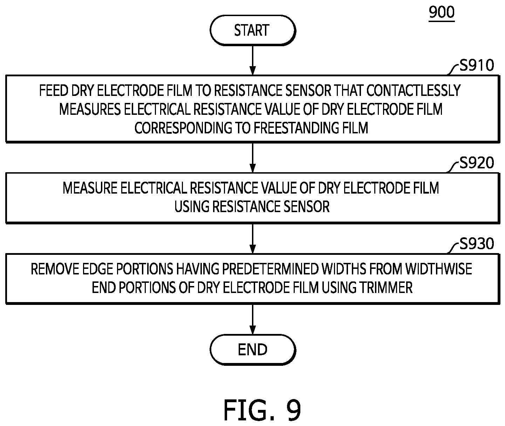

FIG. 9 illustrates a flowchart showing an example of a method 900 according to one or more embodiments of the present disclosure.

In an embodiment, the method 900 may be executed by at least one processor. The method 900 may start when the processor rotates rollers, and feeds a dry electrode film to a resistance sensor that contactlessly measures an electrical resistance value of a dry electrode film corresponding to a freestanding film (S910). The processor may measure the electrical resistance value of the dry electrode film using the resistance sensor (S920).

In an embodiment, before or after the measuring of the electrical resistance value of the dry electrode film, the processor may remove edge portions having widths (e.g., predetermined widths) from widthwise end portions of the dry electrode film using a trimmer (S930). In addition, the processor may detect a defect point of the dry electrode film based on the electrical resistance value measured by the resistance sensor, the measurement time, and the movement speed of the dry electrode film, and the method 900 may end.

In an embodiment, the processor may measure the electrical resistance value of the dry electrode film from which the edge portions have been removed using a first resistance sensor. In this case, the first resistance sensor may include a plurality of sensors that are arranged in a line in the width direction of the dry electrode film from which the edge portions are removed. In another example, the first resistance sensor may be moved back and forth in the width direction of the dry electrode film from which the edge portions are removed.

In an embodiment, the processor may measure the electrical resistance value of the dry electrode film before removing the edge portions by using a second resistance sensor. In this case, the processor may determine whether the dry electrode film is defective based on the electrical resistance value measured by the first resistance sensor and the electrical resistance value measured by the second resistance sensor.

In an embodiment, the processor may control the movement speed of the dry electrode film from which the edge portions are removed by using the tension controller. In addition, the processor may measure the electrical resistance value of the dry electrode film, the movement speed of which is controlled by the tension controller, by using the second resistance sensor.

The methods described above may be provided as a computer program stored on a computer-readable recording medium for execution on a computer. The medium may be a medium that continuously stores a computer-executable program, or may be a medium that temporarily stores a computer-executable program for execution or download. The medium may also be a variety of recording or storage means, including a single piece of hardware or a combination of several pieces of hardware, and may be distributed over a network, rather than being limited to a medium that is directly connected to any computer system. Examples of the media may include magnetic media, such as a hard disk, a floppy disk, and magnetic tape; optical recording media, such as CD-ROM and a DVD; magneto-optical media, such as a floptical disk; and other media configured to store program instructions, including ROM, RAM, flash memory, and the like. In addition, other examples of media may include an app store that distributes applications, a site that provides or distributes various other software, and a recording or storage medium maintained by a server or the like.

The methods, actions, or techniques of the present disclosure may be implemented by a variety of means. For example, these techniques may be implemented in hardware, firmware, software, or a combination thereof. Persons having ordinary knowledge in the art will understand that the various illustrative logical blocks, modules, circuits, and algorithmic steps described in connection with the present disclosure may be implemented in electronic hardware, computer software, or a combination thereof. To clearly illustrate such interchangeability of hardware and software, the various exemplary components, blocks, modules, circuits, and steps have been described above generally in terms of their functions. Whether such functions are implemented in hardware or software depends on the design requirements imposed on the specific application and the overall system. Persons having ordinary knowledge in the art may implement the functions described in various manners for each particular application, but such implementations should not be construed as departing from the scope of the present disclosure.

In hardware implementations, the processing units used to perform the techniques may include one or more ASICs, DSPs, GPUs, digital signal processing devices (DSPDs), programmable logic devices (PLDs), field programmable gate arrays (FPGAs), processors, controllers, microcontrollers, microprocessors, electronics, electronic devices, other electronic units designed to perform the functions described herein, a computer, or a combination thereof.

Accordingly, the various exemplary logic blocks, modules, and circuits described in connection with the present disclosure may be implemented or performed with a general purpose processor, a DSP, an ASIC, an FPGA or other programmable logic devices, a discrete gate or transistor logic, discrete hardware components, or any combination of those designed to perform the functions described herein. The general-purpose processor may be a microprocessor, but in another example, may be any conventional processor, controller, microcontroller, or state machine. The processor may also be implemented as a combination of computing devices, e.g., a DSP and a microprocessor, a plurality of microprocessors, one or more microprocessors associated with a DSP core, or any other combination of configurations.

In firmware and/or software implementations, the techniques may be implemented as instructions stored on a computer-readable medium, such as random access memory (RAM), read-only memory (ROM), non-volatile random access memory (NVRAM), programmable read-only memory (PROM), erasable programmable read-only memory (EPROM), electronically erasable PROM (EEPROM), flash memory, and other random access memory (ROM); (NVRAM), programmable read-only memory (PROM), erasable programmable read-only memory (EPROM), electrically erasable PROM (EEPROM), flash memory, a compact disc (CD), or a magnetic or optical data storage device. The instructions may be executable by one or more processors, and may cause the processor(s) to perform certain aspects of the functions described herein.

When implemented as software, the techniques may be one or more instructions or codes stored on or transmitted through a computer-readable medium. Computer-readable media include both computer storage media and communication media, including any media that facilitate the transmission of a computer program from one location to another. The storage media may be any available medium that can be accessed by a computer. As non-limiting examples, such computer-readable media may include RAM, ROM, EEPROM, CD-ROM or other optical disk storage, magnetic disk storage or other magnetic storage devices, or any other media that may be used to transfer or store desired program codes in the form of instructions or data structures and that may be accessed by a computer. In addition, any access to the computer-readable medium is performed in an appropriate manner.

The software module may reside in RAM memory, flash memory, ROM memory, EPROM memory, EEPROM memory, registers, a hard disk, a removable disk, CD-ROM, or any other type of storage medium known in the art. The exemplary storage medium may be connected to a processor, so that the processor can read information from the storage medium or write information to the storage medium. In another example, the storage medium may be integrated with the processor. The processor and the storage medium may reside in an ASIC. The ASIC may reside in a user terminal. In another example, the processor and the storage medium may be present as separate components in the user terminal.

Although the embodiments described above are described as utilizing aspects of the present disclosure on one or more stand-alone computer systems, the present disclosure is not limited thereto and may be implemented in connection with any computing environment, such as a network or distributed computing environment. Furthermore, aspects of the present disclosure may be implemented on a plurality of processing chips or devices, and storage may be similarly affected across a plurality of devices. Such devices may include PCs, network servers, and portable devices.

Although the present disclosure has been described above with respect to embodiments thereof, the present disclosure is not limited thereto. Various modifications and variations may be made thereto by those skilled in the art within the present disclosure and the equivalent scope of the appended claims.

### Description of Reference Symbols

110: dry electrode film
112: central portion
114: edge portion
120: resistance sensor
210: dry electrode film
230: roller
410: dry electrode film
420: resistance sensor
430: roller

## Claims

1. An apparatus for inspecting a dry electrode, the apparatus comprising:
a feeder configured to feed a dry electrode film (110, 210, 410, 610, 710, 812) corresponding to a freestanding film;
a resistance sensor (120, 220_1, 220_2, 220_3, 420, 620_1, 620_2, 620_3, 620_4, 720, 814) configured to contactlessly measure an electrical resistance value of the dry electrode film (110, 210, 410, 610, 710, 812) fed by the feeder; and
a trimmer (640, 730) configured to remove an edge portion (114, 614) having a width from a widthwise end portion of the dry electrode film (110, 210, 410, 610, 710, 812).

2. The apparatus as claimed in claim 1, wherein the resistance sensor (120, 220_1, 220_2, 220_3, 420, 620_1, 620_2, 620_3, 620_4, 720, 814) comprises a first resistance sensor (420, 620_3, 620_4, 720) configured to measure the electrical resistance value of the dry electrode film (410, 610, 710) from which the edge portion (614) is removed by the trimmer (640, 730).

3. The apparatus as claimed in claim 2, wherein the first resistance sensor (420, 620_3, 620_4, 720) comprises a plurality of sensors (620_3, 620_4) in a line in a width direction of the dry electrode film (610) from which the edge portion (614) is removed.

4. The apparatus as claimed in claim 2 or 3, wherein the first resistance sensor (420, 620_3, 620_4, 720) is configured to be moved back and forth in a width direction of the dry electrode film (410) from which the edge portion is removed.

5. The apparatus as claimed in any one of claims 1 to 4, wherein the resistance sensor (120, 220_1, 220_2, 220_3, 420, 620_1, 620_2, 620_3, 620_4, 720, 814) further comprises a second resistance sensor (620_1, 620_2) configured to measure the electrical resistance value of the dry electrode film (610) before the edge portion is removed.

6. The apparatus as claimed in any one of claims 1 to 5, further comprising a tension controller (750) configured to control a movement speed of the dry electrode film (710) fed by the feeder.

7. The apparatus as claimed in claim 6, wherein the resistance sensor (120, 220_1, 220_2, 220_3, 420, 620_1, 620_2, 620_3, 620_4, 720, 814) comprises a third resistance sensor configured to measure the electrical resistance value of the dry electrode film (710), the movement speed of which is controlled by the tension controller 750.

8. The apparatus as claimed in claim 6 or 7, wherein the tension controller (750) comprises at least one of a dancer roll or an accumulator roll.

9. The apparatus as claimed in any one of claims 1 to 8, wherein the feeder is configured to feed the dry electrode film (110, 210, 410, 610, 710, 812) at a speed of 1 m/min to 500 m/min.

10. The apparatus as claimed in claim 1, further comprising a defect detector configured to detect a defect point (816) of the dry electrode film (812) based on the electrical resistance value measured by the resistance sensor (814), a measurement time, and/or a movement speed of the dry electrode film (812).

11. A method of inspecting a dry electrode, the method comprising:
feeding (S910) a dry electrode film (110, 210, 410, 610, 710, 812) corresponding to a freestanding film to a resistance sensor (120, 220_1, 220_2, 220_3, 420, 620_1, 620_2, 620_3, 620_4, 720, 814) configured to contactlessly measure an electrical resistance value of the dry electrode film (110, 210, 410, 610, 710, 812); and
measuring (S920) the electrical resistance value of the dry electrode film (110, 210, 410, 610, 710, 812) using the resistance sensor (120, 220_1, 220_2, 220_3, 420, 620_1, 620_2, 620_3, 620_4, 720, 814).

12. The method as claimed in claim 11, further comprising removing (S930) an edge portion (114, 614) having a width from a widthwise end portion of the dry electrode film (110, 210, 410, 610, 710, 812).

13. The method as claimed in claim 12, wherein the measuring (S920) of the electrical resistance value of the dry electrode film (410, 610, 710) comprises measuring the electrical resistance value of the dry electrode film (410, 610, 710) from which the edge portion (614) is removed by using a first resistance sensor (420, 620_3, 620_4, 720).

14. The method as claimed in claim 12 or 13, wherein the measuring (S920) of the electrical resistance value of the dry electrode film (610) comprises measuring the electrical resistance value of the dry electrode film (610) before the edge portion (614) is removed by using a second resistance sensor (620_1, 620_2).

15. The method as claimed in claim 14, further comprising determining whether or not the dry electrode film (610) is defective based on the electrical resistance value measured by the first resistance sensor (620_3, 620_4) and the electrical resistance value measured by the second resistance sensor (620_1, 620_2).
